# EUROPÄISCHE PATENTANMELDUNG

(11) **EP 1 103 817 A2**
(43) Veröffentlichungstag der Anmeldung: **30.05.2001**
(21) Anmeldenummer: 00125472.1
(22) Anmeldetag: 21.11.2000
(51) Int. Cl.: G01R 15/18

(54) **Schaltungsanordnung zur Bestimmung des Stroms durch mindestens zwei induktive Bauteile**

(30) Priorität: 24.11.1999 DE 19956399
(71) Anmelder: DaimlerChrysler AG, 70567 Stuttgart (DE)
(72) Erfinder: Börner, Peter, 90425 Nürnberg (DE); Gebhart, bernd, 90556 Senkendorf (DE); Krawczyk, Stefan, 91161 Hilpoltstein (DE); Schürrlein, Andreas, 91056 Erlangen (DE)
(74) Vertreter: Mader, Wilfried

(57) **Zusammenfassung**

2.1 Vorgeschlagen wird eine einfache und kostengünstige Schaltungsanordnung, bei der ein erster Anschluß jedes induktiven Bauteils jeweils mit einem ersten Anschluß mindestens eines Meßwiderstands verbunden ist.
2.2 Zur Bestimmung des Stroms durch eines der induktiven Bauteile sind die beiden Anschlüsse der Meßwiderstände mit einer Schalteinheit zur Selektion des diesem induktiven Bauteil zugeordneten Meßwiderstands verbunden. Am Ausgang der Schalteinheit liegt eine Meßspannung als Maß für die Stromstärke des Stroms durch das mit dem selektierten Meßwiderstand verbundene induktive Bauteil an.

## Beschreibung

Induktive Bauteile, bsp. induktive Aktoren, werden in vielen Anwendungsgebieten eingesetzt, bsp. im Kraftfahrzeugbereich in Steuergeräten als elektro-pneumatische Wandler oder Proportionalventile (Magnetventile). Diese induktiven Bauteile bestehen in der Regel aus einem Elektromagneten (einer Spule) und einem beweglichen Anker, wobei die mit dem Elektromagneten erzeugte und den Anker bewegende magnetische Feldstärke proportional zum Strom durch den Elektromagneten (die Spule) ist.
In einigen Anwendungsfällen ist es erforderlich, die durch die induktiven Bauteile fließenden Ströme (den jeweiligen Spulenstrom) zu bestimmen - bsp. um auf (insbesondere bei externen Einflüssen oder Störgrößen auftretende) Veränderungen der Betriebsbedingungen des induktiven Bauteils angemessen reagieren zu können (bsp. auf eine Änderung des Spulenwiderstands infolge Erwärmung); um die induktiven Bauteile entsprechend gewünschter Vorgaben zu steuern oder zu regeln, müssen die Spulenströme bzw. deren Verhältnisse mit einer hohen Genauigkeit bestimmt werden.
Die Bestimmung der Spulenströme erfolgt mittels Meßwiderständen (Shunts), an denen eine Meßspannung als Maß für den jeweiligen Spulenstrom abfällt. Üblicherweise ist für jeden Meßwiderstand zur Verarbeitung der jeweiligen Meßspannung eine separate Auswerteeinheit vorgesehen, wodurch die Bestimmung der Spulenströme aufwendig und aufgrund unterschiedlicher Charakteristiken der verschiedenen Auswerteeinheiten (bsp. bedingt durch Toleranzen der Bauelemente, Drifts etc.) ungenau wird.
Der Erfindung liegt die Aufgabe zugrunde, eine Schaltungsanordnung nach dem Oberbegriff des Patentanspruchs 1 anzugeben, die auf einfache und kostengünstige Weise realisiert werden kann und mit der die Ströme durch die induktiven Bauteile mit einer hohen Genauigkeit bestimmt werden können.
Diese Aufgabe wird erfindungsgemäß durch die Merkmale im Kennzeichen des Patentanspruchs 1 gelöst.
Vorteilhafte Ausgestaltungen der Schaltungsanordnung ergeben sich aus den weiteren Patentansprüchen.

Die Bestimmung des Stroms durch das jeweilige induktive Bauteil, d.h. die Bestimmung des jeweiligen Spulenstroms, erfolgt mittels eines in Reihe zum induktiven Bauteil (zur jeweiligen Spule) geschalteten Meßwiderstands (Shunts), der die Spannungsverhältnisse so wenig wie möglich beeinflussen soll. Hierbei ist jedem induktiven Bauteil mindestens ein (niederohmiger) Meßwiderstand zugeordnet, der eine Meßspannung als Maß für die Stromstärke des Stroms durch das jeweilige induktive Bauteil bereitstellt. Aus Redundanzgründen (bsp. zum Erkennen von fehlerhaften Messungen und/oder Drift in den Eigenschaften der Meßwiderstände) oder zur Ermittlung von Referenzwerten können einem induktiven Bauteil auch weitere Meßwiderstände zugeordnet werden (diese Meßwiderstände sind dann in Reihe zueinander angeordnet) und deren Meßspannung erfaßt werden; ein Anschluß eines Meßwiderstands der einem induktiven Bauteil zugeordneten Meßwiderstände ist an ein Referenzpotential angeschlossen, bsp. an die Betriebsspannung (bsp. +12 V). Die beiden Anschlüsse der Meßwiderstände sind mit einer Schalteinheit verbunden, mittels der jeweils einer der Meßwiderstände selektiert wird und damit jeweils die Bestimmung des Stroms durch eines der induktiven Bauteile (d.h. die Bestimmung eines Spulenstroms) vorgenommen wird. Hierzu weist die Schalteinheit zwei Umschalter mit jeweils einem Schalter und einer der Anzahl der Meßwiderstände entsprechenden Anzahl an Schaltpositionen auf, wobei die beiden Anschlüsse der Meßwiderstände jeweils mit einer der Schaltpositionen der beiden Umschalter (der gleichen Schaltposition in beiden Umschaltern) verbunden sind; durch die momentan eingenommene Schaltposition der Schalter in beiden Umschaltern wird somit einer der Meßwiderstände und damit eines der induktiven Bauteile ausgewählt. Die beiden die jeweilige Schaltposition in den beiden Umschaltern einstellenden Schalter sind mit einer Steuereinheit verbunden, durch deren Umschaltsignal ein synchrones Umschalten der beiden Schalter in die momentan gewünschte (jeweils gleiche) Schaltposition ermöglicht wird. Am Ausgang der Schalteinheit liegt die gewünschte Meßspannung als Maß für die Stromstärke des Stroms durch das mit dem selektierten Meßwiderstand verbundene induktive Bauteil an. Diese Meßspannung wird einer Signalverarbeitungseinheit zugeführt, in der vorzugsweise ein Vergleich von mindestens zwei Meßspannungen vorgenommen wird; diese Meßspannungen können aufgrund der Selektion von den gleichen induktiven Bauteilen zugeordneten Meßwiderständen und/oder aufgrund der Selektion von unterschiedlichen induktiven Bauteilen zugeordneten Meßwiderständen gewonnen werden. Beim Vergleich der Meßspannungen kann weiterhin eine aufgrund einer Referenzmessung (Eichmessung) mit einem Strom mit definierter Stromstärke gewonnene Referenzspannung als Referenzwert herangezogen werden, insbesondere dann, wenn jedem induktiven Bauteilen nur ein Meßwiderstand zugeordnet ist und deren Meßspannungen verglichen werden. Die Signalverarbeitungseinheit weist bsp. eine der Schalteinheit nachgeschaltete Verstärkereinheit zur Verstärkung der Meßspannung und/oder eine Auswerteeinheit zur Weiterverarbeitung bzw. Auswertung der Meßspannung und/oder der verstärkten Meßspannung auf. Die Verstärkereinheit weist bsp. einen Operationsverstärker auf, dessen beide Eingänge jeweils mit einem Ausgang eines der beiden Umschalter verbunden sind. Die Auswerteeinheit enthält bsp. einen Microcontroller, der bsp. aus der (verstärkten) Meßspannung ein (bsp. digitales) Steuersignal generiert. In Abhängigkeit dieses Steuersignals und damit des Momentanwerts des jeweiligen Stroms durch das entsprechende induktive Bauteil können bestimmte Funktionen gesteuert und/oder geregelt werden, bsp. bestimmte Abläufe während des Betriebs eines Kraftfahrzeugs.
Die Schalteinheit und die Signalverarbeitungseinheit sollten die Spannungsverhältnisse und damit die Meßspannung und auch die Bestimmung der Ströme durch die induktiven Bauteile so wenig wie möglich beeinflussen: daher wird die Schalteinheit so ausgebildet, daß sie (bzw. die Schaltpositionen) im geschlossenen Zustand niederohmig und im offenen Zustand hochohmig ist; die Signalverarbeitungseinheit wird so ausgebildet, daß ihr Eingang (bsp. der Eingang der Verstärkereinheit) hochohmig ist.
Der Stromfluß durch das jeweilige induktive Bauteil wird bsp. mittels einer von einer Ansteuereinheit generierten und dem induktiven Bauteil zugeordneten Pulsweitenmodulation (PWM) gesteuert: mit dem Pulsweitenmodulationssigal der PWM wird ein Schaltelement beaufschlagt, in dessen Abhängigkeit der Stromfluß durch das jeweilige induktive Bauteil ermöglicht oder gesperrt wird.

Vorteilhafterweise kann mit der einfachen und billigen Schaltungsanordnung eine Bestimmung des Stroms durch mehrere induktive Bauteile mit der gleichen Signalverarbeitungseinheit (Verstärkereinheit und/oder Auswerteeinheit) vorgenommen werden, so daß bei der Verarbeitung bzw. Auswertung der durch die Meßwiderstände bereitgestellten Meßspannung bauteilspezifische Abweichungen oder Toleranzen keine Rolle spielen und daher eine präzise Bestimmung des jeweiligen Stroms ermöglicht wird. Weiterhin können durch den Vergleich mindestens zweier Meßspannungen die Verhältnisse der Ströme mit sehr hoher Genauigkeit bestimmt werden und hierdurch Meßfehler oder systematische Fehler, bsp. bedingt durch fehlerhafte Komponenten der Schaltungsanordnung oder durch Änderungen der Eigenschaften der Komponenten der Schaltungsanordnung (bsp. aufgrund von Driften oder Temperatureinflüssen), erkannt werden.

Die Erfindung soll nachstehend im Zusammenhang mit der Zeichnung beschrieben werden.
Dabei zeigen:
- Figur 1: das Prinzipschaltbild der Schaltungsanordnung zur Bestimmung des Stroms durch mehrere induktive Bauteile,
- Figur 2: ein erstes Ausführungsbeispiel der Schaltungsanordnung,
- Figur 3: ein zweites Ausführungsbeispiel der Schaltungsanordnung.

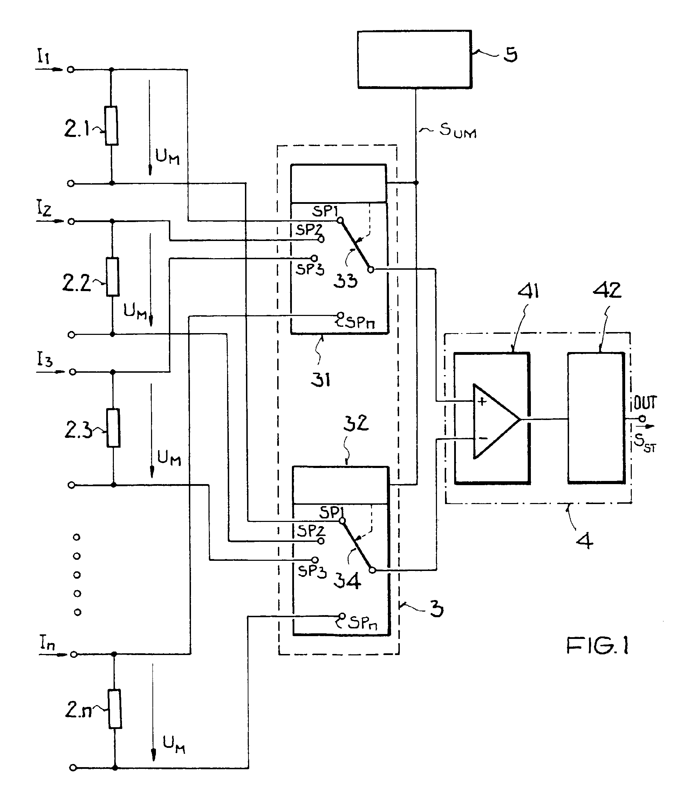

Gemäß dem Prinzipschaltbild der Figur 1 ist zur Bestimmung der Ströme l1, l2, ....., In durch eine beliebige Anzahl (n) induktiver Bauteile jedem der induktiven Bauteile ein Meßwiderstand 2.1, 2.2, ...., 2.n zugeordnet, d.h. es sind zur Bestimmung der Ströme l1, l2, ....., In n Meßwiderstände 2.1, 2.2, ...., 2.n vorgesehen; der Spannungsabfall U_{M} an den Meßwiderständen 2.1, 2.2, ...., 2.n ist somit ein Maß für den Strom I1, I2 ....., In durch das jeweils zugehörige induktive Bauteil. Diese Meßspannung U_{M} wird über eine Schalteinheit 3 der Verstärkereinheit 41 der Signalverarbeitungseinheit 4 zugeführt, von dieser Verstärkereinheit 41 verstärkt und einer Auswerteeinheit 42 der Signalverarbeitungseinheit 4 zugeführt, die aus der verstärkten Meßspannung U_{M} ein Steuersignal S_{ST}, als Ausgangssignal generiert und an ihrem Ausgang OUT zur Verfügung stellt. Die Schalteinheit 3 besteht aus den beiden Umschaltern 31, 32, die jeweils eine der Anzahl n der Meßwiderstände 2.1, 2.2, ...., 2.n entsprechende Anzahl an Schaltpositionen SP1, SP2, ....., SPn und einen Schalter 33, 34 zur Selektion der jeweiligen Schaltposition SP1, SP2, ....., SPn aufweisen. Die beiden Anschlüsse der Meßwiderstände 2.1, 2.2, ...., 2.n sind mit der gleichen Schaltposition SP1, SP2, ....., SPn der beiden Umschalter 31, 32 verbunden, so daß durch eine Schaltposition SP1, SP2, ....., SPn ein bestimmter Meßwiderstand 2.1, 2.2, ...., 2.n selektiert wird. Die Schalter 33, 34 der beiden Umschalter 31, 32 werden durch ein von einer Steuereinheit 5 generiertes Umschaltsignal S_{UM} angesteuert und synchron zwischen den verschiedenen Schaltpositionen SP1, SP2, ....., SPn in jeweils die gleiche Schaltposition SP1, SP2, ....., SPn umgeschaltet, je nachdem welcher der Ströme l1, l2, ....., In bestimmt werden soll. Zur Verstärkung der vom jeweiligen Meßwiderstand 2.1, 2.2, ...., 2.n bereitgestellten und von der Schalteinheit 3 selektierten Meßspannung U_{M} weist die Verstärkereinheit 41 der Signalverarbeitungseinheit 4 bsp. einen als Operationsverstärker ausgebildeten Verstärker auf, dessen nicht-invertierender Eingang (+) mit der durch den Schalter 33 selektierten Schaltposition SP1, SP2, ....., SPn des ersten Umschalters 31 und dessen invertierenden Eingang (-) mit der durch den Schalter 34 selektierten korrespondierenden Schaltposition SP1, SP2, ....., SPn des zweiten Umschalters 32 verbunden ist. Am Ausgang des Operationsverstärkers ist bsp. eine als Microcontroller ausgebildete Auswerteeinheit 42 vorgesehen, deren Eingangsstufe bsp. aus einem A/D-Wandler zur Umwandlung der verstärkten analogen Meßspannung U_{M} in ein digitales Ausgangssignal SST besteht.
Durch Vergleich mehrerer, von unterschiedlichen induktiven Bauteilen zugeordneten Meßwiderständen 2.1, 2.2, ...., 2.n gewonnenen Meßspannungen U_{M}, insbesondere auch unter Heranziehung von in der Auswerteeinheit 42 gespeicherten, mittels Referenzmessungen gewonnenen Referenzspannungen, können die Eigenschaften der Komponenten der Schaltungsanordnung überprüft werden, insbesondere die Meßwiderstände 2.1, 2.2, ...., 2.n selbst und die Komponenten der Signalverarbeitungseinheit 4.

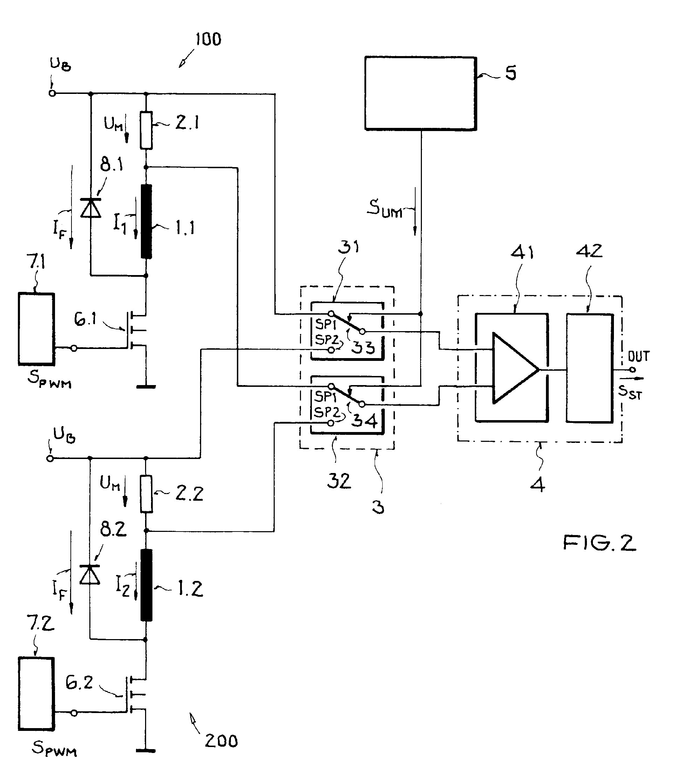

Gemäß dem Ausführungsbeispiel der Figur 2 ist eine Schaltungsanordnung mit den Stromzweigen 100; 200 zweier induktiver Bauteile 1.1, 1.2 dargestellt. Hierbei enthält jeder der Stromzweige 100, 200 ein induktives Bauteil 1.1; 1.2, dessen erster Anschluß mit dem Meßwiderstand 2.1; 2.2 (Shunt) mit einem Widerstandswert von bsp. jeweils 50 mΩ verbunden ist. Zur Realisierung variabler Ströme durch die induktiven Bauteile 1.1, 1.2 ist eine **P**uls**w**eiten**m**odulation (PWM) vorgesehen; bei dieser wird der Elektromagnet (die Spule) des induktiven Bauteils 1.1, 1.2 getaktet bestromt, indem von einer Ansteuerschaltung 7.1, 7.2 mittels eines Pulsweitenmodulationssignals S_{PWM} durch Ansteuerung des mit dem zweiten Anschluß des induktiven Bauteils 1.1, 1.2 verbundenen Schaltelements (bsp. eines Feldeffekt-Transistors) ein bestimmtes Tastverhältnis (Puls-Pause-Verhältnis) variierbar vorgegeben und hierdurch der Stromfluß durch den Elektromagneten (die Spule) und damit durch das induktive Bauteil 1.1, 1.2 eingestellt: während der Pulsdauer (Ansteuerphase) wird das Schaltelement 6.1, 6.2 geschlossen, so daß das induktive Bauteil 1.1, 1.2 mit der Versorgungsspannung U_{B} beaufschlagt wird und ein exponentiell ansteigender Spulenstrom l1, l2 als Ansteuerstrom durch das induktive Bauteil 1.1, 1.2 und den Meßwiderstand 2.1, 2.2 fließt; in der Pulspause (Freilaufphase) wird das Schaltelement 6.1, 6.2 geöffnet, so daß das induktive Bauteil 1.1, 1.2 von der Versorgungsspannung U_{B} getrennt wird und der Spulenstrom 11, 12 infolge der Selbstinduktion als Freilaufstrom I_{F} über die Freilaufdiode 8.1, 8.2 fließt und sich allmählich abbaut.
Der mit dem induktiven Bauteil 1.1, 1.2 verbundene erste Anschluß des Meßwiderstands 2.1, 2.2 und der mit der Versorgungsspannung U_{B} (bsp. im Kraftfahrzeug mit der Klemme 15) verbundene zweite Anschluß des Meßwiderstands 2.1, 2.2 werden in der Schalteinheit 3 den beiden Umschaltern 31, 32 zugeführt, die jeweils einen zwischen zwei Schaltpositionen SP1, SP2 umschaltbaren, von einer Steuereinheit 5 angesteuerten Schalter 33; 34 aufweisen. Die Verarbeitung der von den beiden Meßwiderständen 2.1, 2.2 bereitgestellten Meßspannung U_{M} als Maß für den durch das jeweilige induktive Bauteil 1.1; 1.2 fließenden Stroms 11; 12 erfolgt wie anhand der Figur 1 beschrieben.
In einem Anwendungsfall ist an der Vorderachse und der Hinterachse eines Kraftfahrzeugs jeweils ein Magnetventil als induktives Bauteil 1.1; 1.2 zur Vorgabe des Bremsdrucks an der jeweiligen Achse vorgesehen; in Abhängigkeit des durch die beiden Magnetventile fließenden Stroms l1; l2 erfolgt eine Steuerung der Bremsdruckverteilung zwischen der Bremse der Hinterachse und der Bremse der Vorderachse des Kraftfahrzeugs.

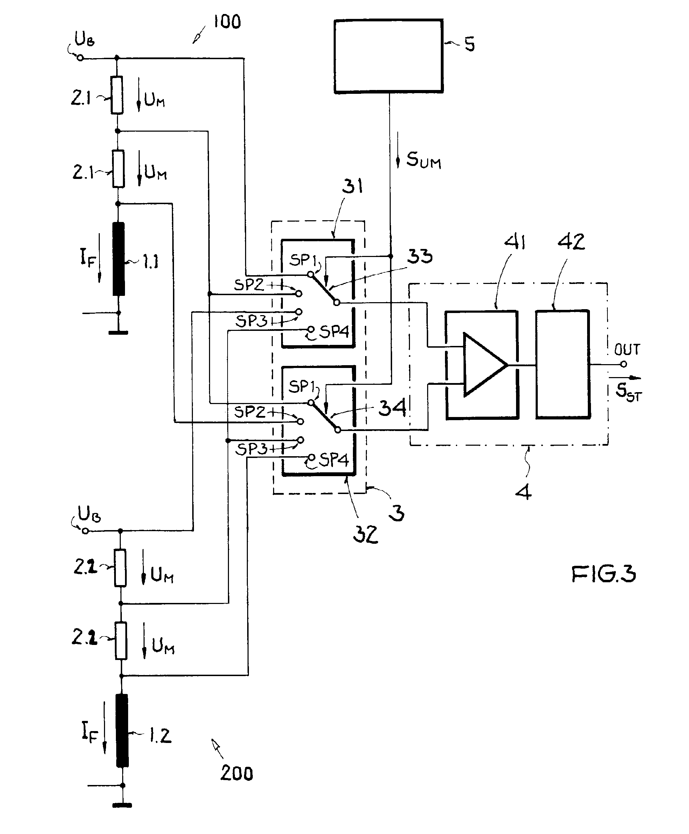

Gemäß dem Ausführungsbeispiel der Figur 3 ist eine Schaltungsanordnung mit den Stromzweigen 100; 200 zweier induktiver Bauteile 1.1, 1.2 dargestellt. Hierbei enthält jeder der Stromzweige 100, 200 ein induktives Bauteil 1.1; 1.2 und zwei in Reihe angeordnete Meßwiderstände (Shunts) 2.1; 2.2 (Widerstandswerte bsp. jeweils 50 mΩ), d.h. jedem der beiden induktiven Bauteile 1.1; 1.2 sind zwei Meßwiderstände 2.1; 2.2 zugeordnet; ein Anschluß jedes induktiven Bauteils 1.1; 1.2 ist hierbei mit dem ersten Anschluß des ersten dem jeweiligen induktiven Bauteil 1.1; 1.2 zugeordneten Meßwiderstands 2.1; 2.2 verbunden, dessen zweiter Anschluß mit dem zweiten Anschluß des zweiten dem jeweiligen induktiven Bauteil 1.1; 1.2 zugeordneten Meßwiderstands 2.1; 2.2 verbunden ist. Der erste Anschluß des zweiten dem jeweiligen induktiven Bauteil 1.1; 1.2 zugeordneten Meßwiderstands 2.1; 2.2 ist mit der Versorgungsspannung U_{B} (bsp. im Kraftfahrzeug mit der Klemme 15) verbunden. Die beiden Anschlüsse der beiden einem induktiven Bauteil 1.1; 1.2 zugeordneten Meßwiderstände 2.1; 2.2 werden in der Schalteinheit 3 den beiden Umschaltern 31, 32 zugeführt, die jeweils einen zwischen vier Schaltpositionen SP1, SP2, SP3, SP4 umschaltbaren, von einer Steuereinheit 5 angesteuerten Schalter 33; 34 aufweisen; hierbei werden die entsprechenden Anschlüsse der beiden einem induktiven Bauteil 1.1; 1.2 zugeordneten Meßwiderstände 2.1; 2.2 der gleichen Schaltposition SP1, SP2, SP3, SP4 in den beiden Umschaltern 31, 32 zugeführt. Die Verarbeitung der von den beiden Meßwiderständen 2.1, 2.2 bereitgestellten Meßspannung U_{M} als Maß für den durch das jeweilige induktive Bauteil 1.1; 1.2 fließenden Stroms l1; l2 erfolgt wie anhand der Figur 1 beschrieben. Insbesondere können hier die durch die beiden einem induktiven Bauteil 1.1; 1.2 zugeordneten Meßwiderstände 2.1; 2.2 gewonnenen Meßspannungen U_{M} miteinander verglichen werden; mittels dieses Vergleichs kann eine Überprüfung der Eigenschaften der Komponenten der Schaltungsanordnung ohne Heranziehung von Referenzwerten vorgenommen werden.

## Patentansprüche

1. Schaltungsanordnung zur Bestimmung des Stroms (l1, l2) durch mindestens zwei induktive Bauteile (1.1, 1.2),
dadurch gekennzeichnet,
daß jedem induktiven Bauteil (1.1, 1.2) mindestens ein Meßwiderstand (2.1, 2.2) zugeordnet ist, wobei ein erster Anschluß jedes induktiven Bauteils (1.1, 1.2) jeweils mit einem ersten Anschluß eines zugeordneten Meßwiderstands (2.1, 2.2) verbunden ist,
daß die beiden Anschlüsse der Meßwiderstände (2.1, 2.2) mit einer Schalteinheit (3) zur Selektion eines der Meßwiderstände (2.1, 2.2) verbunden sind,
und daß am Ausgang der Schalteinheit (3) eine Meßspannung (U_{M}) als Maß für die Stromstärke des Stroms (11,12, ...., In) durch das mit dem selektierten Meßwiderstand (2.1; 2.2) verbundene induktive Bauteil (1.1; 1.2) anliegt.

2. Schaltungsanordnung nach Anspruch 1, dadurch gekennzeichnet, daß die Schalteinheit (3) zwei Umschalter (31, 32) mit jeweils einer der Anzahl der Meßwiderstände (2.1, 2.2) entsprechenden Anzahl an Schaltpositionen (SP1, SP2) und jeweils einen Schalter (33, 34) zur Anwahl der Schaltpositionen (SP1, SP2) aufweist, daß jeweils ein Anschluß der Meßwiderstände (2.1, 2.2) mit einer Schaltposition (SP1, SP2) in einem Umschalter (31) und der andere Anschluß der Meßwiderstände (2.1, 2.2) mit der korrespondierenden Schaltposition (SP1, SP2) im anderen Umschalter (32) verbunden ist, und daß die Schalter (33, 34) der beiden Umschalter (31, 32) von einer Steuereinheit (5) mit einem Umschaltsignal (S_{UM}) zur Vorgabe der Schaltpositionen (SP1, SP2) beaufschlagt werden.

3. Schaltungsanordnung nach Anspruch 1 oder 2, dadurch gekennzeichnet, daß der Schalteinheit (3) eine Signalverarbeitungseinheit (4) nachgeschaltet ist, die die aufgrund der Selektion von mindestens zwei Meßwiderständen (2.1, 2.2) gewonnenen Meßspannungen (U_{M}) miteinander vergleicht.

4. Schaltungsanordnung nach Anspruch 3, dadurch gekennzeichnet, daß in der Signalverarbeitungseinheit (4) mindestens ein Referenzwert gespeichert ist, mit dem die Meßspannungen (U_{M}) verglichen werden.

5. Schaltungsanordnung nach Anspruch 3 oder 4, dadurch gekennzeichnet, daß die Signalverarbeitungseinheit (4) eine Verstärkereinheit (41) zur Verstärkung der Meßspannung (U_{M}) aufweist.

6. Schaltungsanordnung nach Anspruch 5, dadurch gekennzeichnet, daß die Verstärkereinheit (41) einen Operationsverstärker aufweist, und daß jeweils der Ausgang eines der beiden Umschalter (31, 32) mit einem Eingang des Operationsverstärkers verbunden ist.

7. Schaltungsanordnung nach einem der Ansprüche 3 bis 6, dadurch gekennzeichnet, daß die Signalverarbeitungseinheit (4) eine Auswerteeinheit (42) zur Auswertung der Meßspannung (U_{M}) oder der verstärkten Meßspannung (U_{M}) aufweist.

8. Schaltungsanordnung nach einem der Ansprüche 1 bis 7, dadurch gekennzeichnet, daß den induktiven Bauteilen (1.1, 1.2) jeweils eine Ansteuerschaltung (7.1, 7.2) zugeordnet ist, die den Stromfluß durch die induktiven Bauteile (1.1, 1.2) mittels Pulsweitenmodulation steuert.

9. Schaltungsanordnung nach Anspruch 8, dadurch gekennzeichnet, daß die zweiten Anschlüsse der induktiven Bauteile (1.1, 1.2) jeweils mit einem Schaltelement (6.1, 6.2 verbunden sind, das mittels eines von der Ansteuerschaltung (7.1, 7.2) generierten Pulsweitenmodulationssignals (S_{PWM}) beaufschlagt wird.

10. Schaltungsanordnung nach einem der Ansprüche 1 bis 9, dadurch gekennzeichnet, daß ein Anschluß eines der einem induktiven Bauteil (1.1, 1.2) zugeordneten Meßwiderstände (2.1, 2.2) an ein Referenzpotential (U_{B}) angeschlossen ist.

11. Schaltungsanordnung nach Anspruch 10, dadurch gekennzeichnet, daß ein Anschluß eines der einem induktiven Bauteil (1.1, 1.2) zugeordneten Meßwiderstände (2.1, 2.2) an die Versorgungsspannung (U_{B}) angeschlossen ist.
